# EUROPÄISCHE PATENTSCHRIFT

(11) **EP 1 340 417 B1**
(45) Veröffentlichungstag und Bekanntmachung des Hinweises auf die Patenterteilung: **29.09.2004**
(21) Anmeldenummer: 01982036.4
(22) Anmeldetag: 19.11.2001
(51) Int. Cl.: H05K 7/20

(54) **ELEKTRONIK-ANORDNUNG**
ELECTRONICS ARRANGEMENT
DISPOSITIF ELECTRONIQUE

(30) Priorität: 08.12.2000 CH 239700
(43) Veröffentlichungstag der Anmeldung: 03.09.2003
(73) Patentinhaber: Delta Energy Systems (Switzerland) AG, 3018 Bern-Bümpliz (CH)
(72) Erfinder: STREIT, Robert, CH-3173 Oberwangen b. Bern (CH); KOOPMANS, Hendrik, CH-3322 Urtenen (CH)
(74) Vertreter: Roshardt, Werner Alfred, Dipl.-Phys.
(86) Internationale Anmeldenummer: PCT/CH2001/000678
(87) Internationale Veröffentlichungsnummer: WO 2002/047453

(56) Entgegenhaltungen:
- DE-U- 29 504 306
- US-A- 3 956 673
- US-A- 5 794 685
- US-A- 5 873 407

## Beschreibung

### Technisches Gebiet

Die Erfindung betrifft eine Elektronik-Anordnung nach dem Oberbegriff des Anspruchs 1.

### Stand der Technik

Elektronik-Anordnungen umfassen üblicherweise eine oder mehrere flache, plattenförmige Tragstrukturen wie z.B. Leiterplatten, auf denen die elektronischen Bauteile angeordnet sind. Oft ist eine Mehrzahl von solchen plattenförmigen Tragstrukturen bzw. Trägerplatten in paralleler Anordnung in einem auch als Rack bezeichneten Gestell und/oder in einem Gehäuse angeordnet.

Zum Abführen der von den elektronischen Bauteilen erzeugten Verlustwärme sind Elektronik-Anordnungen weiter häufig mit einer Vielzahl von Kühlrippen versehen, die in wärmeleitender Funktion mit den elektronischen Bauteilen und/oder der Trägerplatte verbunden sind. Die Verlustwärme wird dann von den elektronischen Bauteilen mittels Wärmeleitung an die Kühlrippen und von diesen mittels Konvektion an die Kühlluft abgeführt. Wenn die Trägerplatten mit integrierten Bauteilen und/oder elektronischen Leistungsbauteilen bestückt werden, die eine hohe Verlustwärme erzeugen, reicht die Wärmeabfuhr mittels Wärmeleitung allein oft nicht aus, um die Bauteile wirksam vor thermisch erzeugten Schäden zu schützen. Ein Lösungsweg besteht in diesem Fall darin, dass die Elektronik-Anordnungen weiter mit einem Ventilator versehen werden, der eine erzwungene Kühlluft-Strömung erzeugt, um die Verlustwärme über die Konvektion abzuführen.

Zur Gewährleistung einer guten Wärmeleitung stehen die Kühlrippen in engem Kontakt mit der Trägerplatte und/oder den elektronischen Bauteilen. Obwohl die Kühlrippen grundsätzlich auch direkt an einer Leiterplatte und/oder an den elektronischen Bauteilen angebracht sein können, sind sie meistens an einem üblicherweise einstückigen Kühlkörper (auch als Heatsink bezeichnet) angeformt, der seinerseits in wärmeleitender Funktion fest mit der Leiter- bzw. der Trägerplatte verbunden ist. Die wärmeerzeugenden Bauteile können direkt mit dem Kühlkörper verbunden sein, sei es, indem ein typisch an solchen Bauteilen angebrachter Kühlteil mittels einer relativ dicken Schraube durch die Leiterplatte hindurch mit dem Kühlkörper verbunden ist, oder indem ein solcher Kühlteil durch eine Aussparung in der Leiterplatte hindurch direkt auf dem Kühlkörper montiert ist. Dabei ist ein solcher Kühlkörper typischerweise mit einer Grundplatte (auch als Kühlkörperplatte bezeichnet) versehen, an welcher die Kühlrippen angeformt sind, wobei die Kühlkörperplatte vorzugsweise eine der zu kühlenden Leiterplatte entsprechende Plattenform hat. Der aus einer Leiterplatte und aus einer dieser entsprechenden Kühlkörperplatte gebildete Verbund ist somit selbst wiederum eine plattenförmige Struktur und dient als Trägerstruktur, an welcher die elektronischen Bauteile und die Kühlrippen angebracht sind. Dabei können entweder eine Leiterplatte und ein mit einer Kühlkörperplatte versehener Kühlkörper als separate Elemente ausgebildet und fest miteinander verbunden sein, oder die Kühlkörperplatte kann von Anfang an als integraler Teil der Leiterplatte ausgebildet sein, um die plattenförmige Trägerstruktur der Elektronik-Anordnung zu bilden. Die mit Kühlrippen und elektronischen Bauteilen versehene Struktur kann weiter mit Abdeckplatten oder ähnlich wirkenden Abdeck- oder Gehäuseelementen versehen sein, welche einen Mantel bilden, der die Kühlluftströmung entlang von vorgegebenen Strömungspfaden leitet. Insbesondere können die Kühlrippen mit im Wesentlichen parallel zur Trägerplatte angeordneten Abdeckelementen abgedeckt sein, so dass sie vierseitig geschlossenen Kühlluft-Kanäle nach Art von Kühlrohren definieren.

In JP 10-233590 wird eine Elektronik-Anordnung mit einer Leiterplatte beschrieben, auf der ein Verlustwärme erzeugendes, flaches elektronisches Bauteil angeordnet ist. Das flache elektronische Bauteil liegt mit einer seiner beiden Hauptseiten auf der Leiterplatte auf, während an der anderen Hauptseite ein mit Kühlrippen versehener Kühlkörper angebracht ist. Die Elektronik-Anordnung umfasst weiter einen Ventilator, welcher eine Kühlluft-Strömung derart erzeugt, dass die Kühlluft den Kühlrippen des Kühlkörpers entlang strömt und diese dabei abkühlt. Gemäss einer in Fig. 4 von JP 10-233590 dargestellten Variante ist der Ventilator direkt auf der Leiterplatte, unmittelbar neben dem Kühlkörper, derart angeordnet, dass seine Achse senkrecht zur Leiterplattenebene steht. Der Ventilator saugt die Kühlluft in axialer Richtung von der von der Leiterplatte abgewandten Seite her an und bläst sie in radialer Richtung (d.h. parallel zur Leiterplattenebene) derart aus, dass sie den Kühlrippen entlang durch den mit einem Mantel versehenen Kühlkörper hindurch strömt.

Die Kühl-Effizienz einer Kühlvorrichtung, wie sie in der JP 10-233590 beschrieben ist, ist eher gering. Zudem nimmt die Kühlvorrichtung selbst im Verhältnis zu den zu kühlenden elektronischen Komponenten einen vergleichsweise grossen Raum ein, was insbesondere im Falle von Elektronik-Anordnungen, die als flache Einheiten in ein Rack einschiebbar sind, unerwünscht ist. Die Einbauhöhe bzw. die Dicke solcher Einschub-Einheiten sollte möglichst klein sein, damit sie in einem kompakten Rack oder in einem kompakten Gerätegehäuse angeordnet werden können.

### Darstellung der Erfindung

Aufgabe der Erfindung ist die Schaffung einer Elektronik-Anordnung mit einer Kühlvorrichtung, die platzsparend ist und eine effiziente Kühlung von elektronischen Bauteilen der Elektronik-Anordnung ermöglicht.

Die Lösung der Aufgabe ist durch die Merkmale des Anspruchs 1 definiert. Gemäss der Erfindung weist eine Elektronik-Anordnung wenigstens einen Ventilator und wenigstens eine im Wesentlichen flache Trägerstruktur auf, die mit einem oder mehreren elektronischen Bauteilen bestückt und mit einer oder mehreren Kühlrippen versehen ist. In der Trägerstruktur ist ein durch diese hindurch führender Kühlluft-Durchgang ausgebildet. Der Ventilator und der Kühlluft-Durchgang sind derart ausgebildet und angeordnet, dass der Ventilator eine Kühlluft-Strömung erzeugt, so dass die Kühlluft zunächst in wenigstens ein elektronisches Bauteil und/oder eine Kühlrippe kühlender Funktion auf der einen Seite der Trägerstruktur entlang strömt, dann durch den Kühlluft-Durchgang hindurch strömt und danach in wenigstens ein elektronisches Bauteil und/oder eine Kühlrippe kühlender Funktion auf der anderen Seite der Trägerstruktur entlang strömt.

Als flache Struktur wird im Zusammenhang mit der vorliegenden Beschreibung und den Ansprüchen eine Struktur bezeichnet, die zwei im Wesentlichen zueinander parallele, flache, als Hauptseiten der Struktur bezeichnete Seiten aufweist, welche wesentlich grössere Oberflächen haben als die übrigen Rand- und/oder Stirnseiten der Struktur. Unter einem durch eine flache Struktur hindurch führenden Durchgang ist ein Durchgang zu verstehen, der im Wesentlichen senkrecht zu den Oberflächen der Hauptseiten durch die beiden Hauptseiten der Struktur hindurch führt.

Die Kühlluft strömt zunächst der Oberfläche auf der einen der beiden Hauptseiten der flachen, plattenförmigen Trägerstruktur entlang und kühlt dabei Bauteile und/oder Kühlrippen, die auf dieser Hauptseite an der Trägerstruktur angeordnet sind. Danach strömt die Kühlluft durch den in der Trägerstruktur ausgebildeten Kühlluft-Durchgang hindurch, der quer zur Plattenebene durch die flache, plattenförmige Struktur hindurch führt. Anschliessend strömt sie der Oberfläche auf der anderen Hauptseite der Trägerstruktur entlang und kühlt dabei Bauteile und/oder Kühlrippen, die auf dieser Hauptseite an der Trägerstruktur angeordnet sind.

Aufgrund des in der Trägerstruktur ausgebildeten Kühlluft-Durchgangs erzeugt der Ventilator eine Kühlluft-Strömung auf beiden Seiten der Trägerstruktur. Dadurch wird die Möglichkeit geschaffen, auf effiziente Art mittels derselben durch den Ventilator erzeugten Kühlluft-Strömung sowohl elektronische Bauteile direkt zu kühlen als auch die von diesen Bauteilen zu Kühlkörpern geleitete und von diesen abgestrahlte Wärme abzuführen. Zudem wird die Dicke der Trägerstruktur bzw. ihre Einbauhöhe durch den Durchgang nicht vergrössert.

Es ist möglich, sämtliche elektronischen Bauelemente auf der ersten Hauptseite und sämtliche Kühlrippen auf der zweiten Hauptseite der Trägerstruktur anzuordnen. Es können aber auch einige oder sogar sämtliche elektronische Bauteile auf der zweiten Hauptseite und einige oder sogar sämtliche Kühlrippen auf der ersten Hauptseite angeordnet sein.

Gemäss einer bevorzugten Ausführungsart der Erfindung ist der Ventilator entweder direkt an der flachen Trägerstruktur selbst oder an einer mit der Trägerstruktur verbundenen Haltevorrichtung angebracht. Eine solche Haltevorrichtung kann z.B. eine Abdeckplatte sein, die zum Abdecken einer der beiden Hauptseiten der Trägerstruktur ausgebildet und an dieser angebracht ist. Die Trägerstruktur mitsamt der oder denAbdeckplatten, dem Ventilator und gegebenenfalls der Ventilator-Haltevorrichtung kann insbesondere als Einheit ausgebildet sein, welche als Ganzes in ein Rack einschiebbar ist. Grundsätzlich ist es aber auch möglich, den Ventilator an einem von der Trägerstruktur entfernten Ort, z.B. an einem geeigneten Ort in einem Gerätegehäuse, anzuordnen.

Der Ventilator ist vorzugsweise derart bemessen und an der Trägerstruktur angeordnet, dass er in Richtung senkrecht zu den Oberflächen der Hauptseiten der flachen Trägerstruktur nicht über die höchsten Bauteile und/oder die höchsten Kühlrippen hinaus vorsteht, um die Dicke der Trägerstruktur bzw. ihre Einbauhöhe nicht zu vergrössern.

Im Falle eines an der Trägerstruktur oder an einer mit der Trägerstruktur verbundenen Haltevorrichtung angebrachten Ventilators ist dieser vorzugsweise in radialer Anordnung unmittelbar beim Kühlluft-Durchgang oder sogar im Kühlluft-Durchgang selbst angeordnet. Dabei ist unter einer radialen Anordnung des Ventilators bezüglich der Trägerstruktur eine Anordnung des Ventilators derart zu verstehen, dass die Ventilatorachse (d.h. die Achse des Flügelrads des Ventilators) im Wesentlichen senkrecht zu den Hauptseiten der flachen Trägerstruktur angeordnet ist. Unter einer Anordnung des Ventilators unmittelbar beim Kühlluft-Durchgang ist zu verstehen, dass der Ventilator in unmittelbarer Umgebung des in der Trägerstruktur ausgebildeten Kühlluft-Durchgangs angeordnet ist. Er kann z.B. mit einer axialen Einlassöffnung zum Kühlluft-Durchgang fluchtend auf einer Hauptseite der Trägerstruktur aufliegend angeordnet sein, in welcher der Kühlluft-Durchgang ausgebildet ist.

Durch die radiale Anordnung des Ventilators in unmittelbarer Umgebung des in der Trägerstruktur ausgebildeten Kühlluft-Durchgangs oder sogar in diesem selbst wird die Möglichkeit geschaffen, einen Ventilator mit einem Flügelrad zu verwenden, das einen vergleichsweise grossen Durchmesser hat, ohne dass dadurch die Einbauhöhe bzw. die Dicke einer Einschubeinheit vergrössert wird, welche die Trägerstruktur mitsamt dem Ventilator umfasst. Ventilatoren mit grossen Flügelrädern sind effizienter und können mit kleineren Tourenzahlen betrieben werden als Ventilatoren mit kleinen Flügelrädem. Dadurch kann der Geräuschpegel gesenkt, die Ausfallwahrscheinlichkeit vermindert und die Lebenserwartung der Ventilatoren vergrössert werden.

Der Ventilator kann an einem axialen Längsende mit einer quer zur Ventilatorachse angeordneten Abdeckung (z.B. in Form einer Deckplatte) versehen sein, welche (im Falle ihrer Anordnung am einlassseitigen Längsende) das Ansaugen bzw. (im Falle ihrer Anordnung am auslassseitigen Längsende) das Ausblasen von Luft in axialer Richtung verhindert. Eine solche Abdeckung kann eine Abdeckplatte sein, die zum Abdecken einer der beiden Hauptseiten der Trägerstruktur ausgebildet und an dieser angebracht ist. Es ist jedoch auch eine Abdeckung in Form einer Abdeckplatte möglich, die lediglich den Ventilatoreinlass bzw. den Ventilatorauslass in axialer Richtung abdeckt und nicht gleichzeitig auch die ganze Hauptseite der Trägerstruktur abdeckt. Weiter kann die Abdeckung gleichzeitig auch als Haltevorrichtung zum Halten des Ventilators ausgebildet sein. Vorzugsweise ist die Trägerstruktur auf der Auslassseite mit einer Abdeckplatte versehen, die vorzugsweise gleichzeitig auch als Kühlkanaldeckel dient.

Der Ventilator kann auch an seinen beiden axialen Längsenden je mit einer quer zur Ventilatorachse angeordneten Abdeckung versehen sein. Er saugt dann Luft auf seiner Einlassseite in der Nähe des einen Längsendes lediglich in radialer Richtung an und bläst Luft auf seiner Auslassseite in der Nähe des anderen Längsendes lediglich in radialer Richtung aus.

Gemäss einer bevorzugten Variante der Erfindung umfasst die Trägerstruktur eine einseitig mit elektronischen Bauteilen bestückte Leiterplatte und eine einseitig mit Kühlrippen versehene Kühlplatte, wobei diese auch als (plattenförmigen) Kühlkörper oder als Heatsink bezeichnete Kühlplatte an ihrer kühlrippenfreien Seite mit der unbestückten Seite der Leiterplatte verbunden ist. Die Trägerstruktur ist dann insgesamt eine flache, plattenförmige Struktur mit zwei Hauptseiten, wobei die eine Hauptseite mit elektronischen Bauteilen bestückt und die andere Hauptseite mit Kühlrippen versehen ist. Vorzugsweise ist die gesamte Trägerstruktur als Einschubeinheit ausgebildet, welche als Ganzes in ein Rack einschiebbar ist. Grundsätzlich sind jedoch auch andere Formen der Trägerstruktur insgesamt und insbesondere der Leiterplatte und/oder des Kühlkörpers möglich.

Die elektronischen Bauteile, die Kühlrippen und der Ventilator einer erfindungsgemässen Elektronik-Anordnung sind vorzugsweise derart angeordnet, dass die durch den Ventilator erzeugte Kühlluft-Strömung zunächst wenigstens ein elektronisches Bauteil auf der einen Seite der Trägerstruktur kühlt, dann durch den Kühlluft-Durchgang hindurch strömt und danach wenigstens eine Kühlrippe auf der anderen Seite der Trägerstruktur kühlt. Dadurch können insbesondere auch diejenigen elektronischen Bauteile effizient gekühlt werden, die nicht in wärmeleitender Funktion mit irgendwelchen Kühlrippen verbunden sind.

Vorteilhafterweise sind wenigstens einige der Kühlrippen einer erfindungsgemässen Elektronik-Anordnung nach Art von Strömungsleitwänden ausgebildet und angeordnet, welche auf wenigstens einer Seite (d.h. auf einer Hauptseite) der Trägerstruktur Kanalwände für die Kühlluft-Strömung definieren. Die Rippen haben dann gleichzeitig zwei Funktionen: Sie dienen einerseits als Kühlrippen, über welche Wärme an die Kühlluft abgeführt wird, und andrerseits als Leitwände oder Kanalwände zum Leiten der Kühlluft-Strömung.

Dabei kann auf der von der Trägerstruktur abgewandten Seite der Kühlrippen, welche die Kühlluft-Kanäle definieren, eine zur flachen Trägerstruktur im Wesentlichen parallele Abdeckplatte oder ein Abdeckelement mit gleicher Funktion wie eine Abdeckplatte derart angeordnet sein, dass wenigstens einer, vorzugsweise sogar sämtliche der Kühlluft-Kanäle auf zwei Seiten durch Kühlrippen, auf einer dritten Seite durch die Trägerstruktur und auf einer dieser dritten Seite gegenüberliegenden vierten Seite durch die Abdeckplatte bzw. das Abdeckelement begrenzt ist. Mittels solchen auf vier Seiten geschlossenen Kühlluft-Kanälen kann ein genau definierter Strömungspfad für die Kühlluft-Strömung geschaffen werden.

Gemäss einer weiteren bevorzugten Ausführungsart der Erfindung ist in der Trägerstruktur wenigstens ein weiterer Kühlluft-Durchgang ausgebildet und sind Strömungsleitmittel derart angeordnet, dass wenigstens ein Teil der Kühlluft nach dem Entlangströmen auf der ersten Seite der Trägerstruktur und dem Durchströmen des von der ersten auf die zweite Seite der Trägerstruktur führenden ersten Kühlluft-Durchgangs durch die Strömungsleitmittel auf der zweiten Seite der Trägerstruktur zum weiteren Kühlluft-Durchgang geleitet wird und durch diesen hindurch wieder auf die erste Seite der Trägerstruktur strömt, um danach wiederum auf der ersten Seite der Trägerstruktur entlang zu strömen und dabei wenigstens ein elektronisches Bauteil und/oder eine Kühlrippe zu kühlen. Die Strömungsleitmittel können z.B. Leitwände oder Leitkanäle sein, welche die Strömung leiten bzw. führen, wobei diese Leitwände oder Leitkanäle vorzugsweise gleichzeitig auch als Kühlrippen zum Kühlen von elektronischen Bauteilen der Elektronik-Anordnung ausgebildet sind. Der weitere Kühlluft-Durchgang ermöglicht die Kühlung von elektronischen Bauteilen und/oder Kühlrippen auch in denjenigen Partien auf der ersten Seite der Trägerstruktur, die von der Kühlluft-Strömung vor deren Durchtritt durch den ersten Kühlluft-Durchgang hindurch nicht überströmt werden. Vorzugsweise sind auf der ersten Seite der Trägerstruktur eine oder mehrere Trennwände vorgesehen, welche die Bereiche um den ersten Kühlluft-Durchgang herum von den Bereichen um den oder die weiteren Kühlluft-Durchgänge herum abgrenzen, um zu verhindern, dass die Kühlluft nach dem Durchströmen des oder der weiteren Durchgänge auf der ersten Seite der Trägerstruktur zum ersten Durchgang zurück strömt und in unerwünschter Weise rezykliert wird. Diese Trennwände können entweder an der Trägerstruktur selbst, auf deren ersten Seite, angeordnet sein, oder sie können auch an einer Abdeckplatte angeordnet sein, die parallel zu dieser ersten Seite angeordnet wird, um zur Plattenebene senkrechte Luftströmungen zu verhindern.

Es ist jedoch auch möglich, dass die Trägerstruktur lediglich einen einzigen Kühlluft-Durchgang aufweist, so dass die gesamte Kühlluft-Strömung entlang der einen Hauptseite der Trägerstruktur angesaugt und entlang der anderen Hauptseite ausgeblasen wird.

Vorteilhafterweise weist die flache Trägerstruktur bis auf den ersten und gegebenenfalls die. weiteren Durchgänge für die Kühlluft-Strömung keinen weiteren durch die Trägerstruktur hindurch führenden luftdurchlässigen Durchgang auf, um einen genau definierten Strömungspfad für die Kühlluft zu gewährleisten.

Der Ventilator, der oder die Kühlluft-Durchgänge und gegebenenfalls die Strömungsleitmittel können derart angeordnet sein, dass die Kühlluft zunächst durch einen Lufteinlass hindurch angesaugt wird, der in der Nähe einer ersten Stirnseite der Trägerstruktur angeordnet ist, und dass die Kühlluft, nachdem sie der Trägerstruktur entlang geströmt ist und dadurch elektronische Bauteile und/oder Kühlrippen gekühlt hat, durch einen Luftauslass hindurch ausgeblasen wird, der in der Nähe einer anderen, von der ersten Stirnseite verschiedenen Stirnseite der Trägerstruktur angeordnet ist. Der Luftauslass kann z.B. in der Nähe derjenigen Stirnseite angeordnet sein, die in Bezug auf die Trägerstruktur gegenüber der ersten Stirnseite angeordnet ist. In diesem Fall kann im Wesentlichen die gesamte Trägerstruktur jeweils abschnittsweise auf der einen oder der anderen Hauptseite von der Kühlluft überströmt werden. Die erste Stirnseite kann z.B. an der Frontseite und die zweite Stirnseite an der Rückseite eines Racks oder eines Gerätegehäuses angeordnet sein, in welches die Trägerstruktur oder die mit Abdeckplatten oder anderen Abdeckelementen zu einer Einschubeinheit zusammengebaute Trägerstruktur eingebaut wird. Nach dem Einbau wird die Kühlluft dann wie üblich auf der Frontseite angesaugt und auf der Rückseite ausgeblasen. Die lufteinlassseitige erste Stirnseite und die luftauslassseitige zweite Stirnseite können jedoch auch an anderen Seiten des Racks bzw. des Gerätegehäuses angeordnet sein, z.B. an dessen Unter- bzw. Oberseite, so dass eine im Wesentlichen von unten nach oben verlaufende Kühlluftströmung entsteht. Es ist auch möglich, die Luft an der Frontseite anzusaugen und an der Oberseite auszublasen, so dass eine Strömung von vorne nach oben entsteht, wobei die Strömung nicht geradlinig zu sein braucht. Aus der nachfolgenden Detailbeschreibung und der Gesamtheit der Patentansprüche ergeben sich weitere vorteilhafte Ausführungsformen und Merkmalskombinationen der Erfindung.

### Kurze Beschreibung der Zeichnungen

Die zur Erläuterung des Ausführungsbeispiels verwendeten Zeichnungen zeigen:
- Fig. 1: eine vereinfachte, perspektivische Ansicht auf eine erste Seite einer Elektronik-Anordnung gemäss einer bevorzugten Ausführungsart der Erfindung;
- Fig. 2: eine vereinfachte, perspektivische Ansicht auf eine zweite Seite der Elektronik-Anordnung aus Fig. 1.

Grundsätzlich sind in den Figuren gleiche Teile mit gleichen Bezugszeichen versehen.

### Wege zur Ausführung der Erfindung

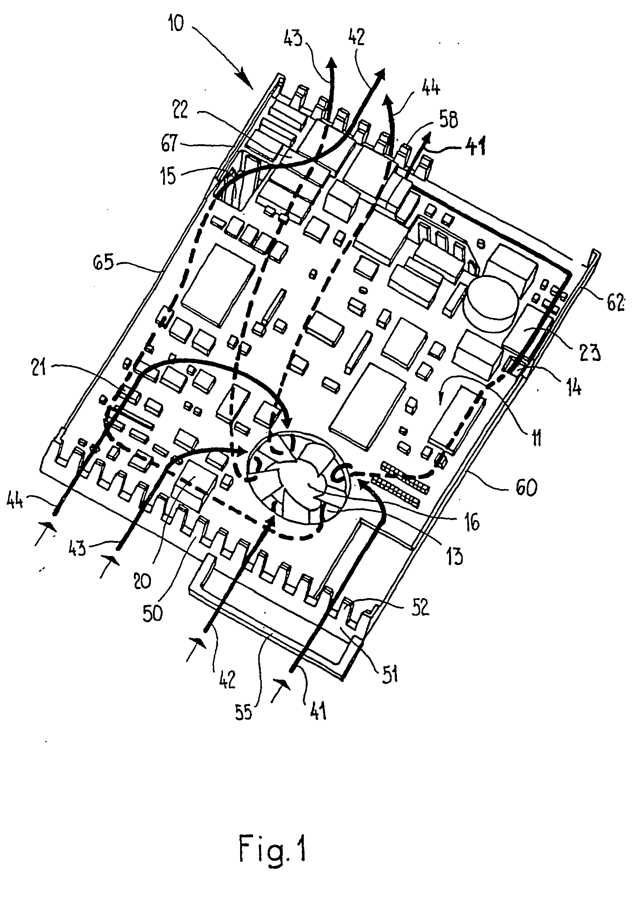

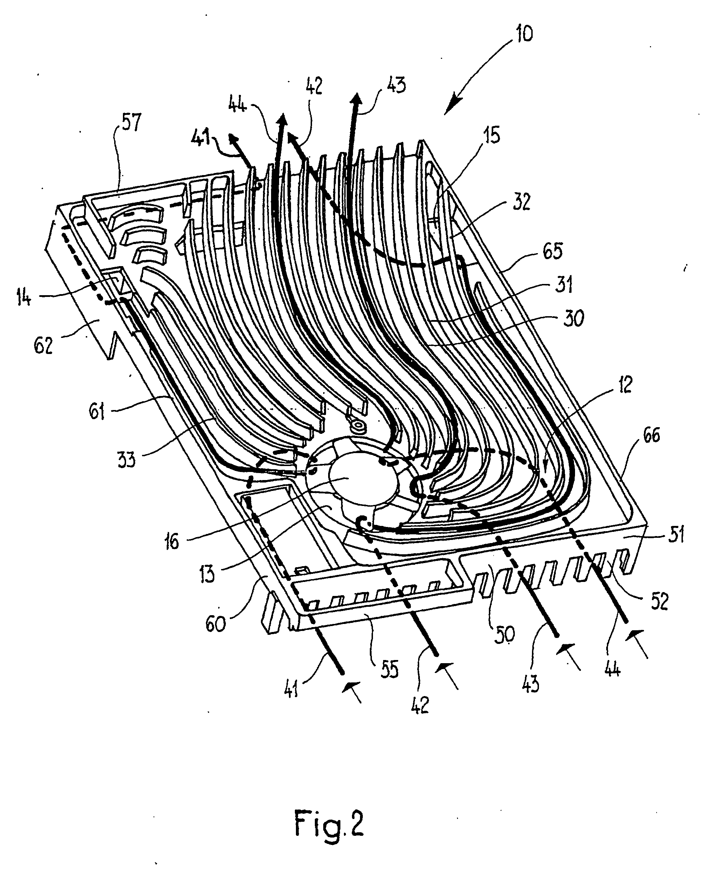

Die in Fig. 1 und 2 dargestellte Elektronik-Anordnung umfasst eine flache Trägerstruktur 10, welche im Wesentlichen aus einer einseitig mit elektronischen Bauteilen 20, 21, 22, 23 bestückten Leiterplatte 11 und einer einseitig mit Kühlrippen 30, 31, 32, 33 versehenen Kühlplatte 12 (auch als Heatsink 12 bezeichnet) besteht. Die Leiterplatte 11 und die Kühlplatte 12 sind beide nach Art von flachen, rechteckigen Platten ausgebildet, mit im Wesentlichen identischen Rechteckformen, wobei die Kühlplatte 12 an ihrer kühlrippenfreien Hauptseite mit der unbestückten Hauptseite der Leiterplatte 11 derart verbunden ist, dass wenigstens ein Teil der Verlustwärme, die von den an der Leiterplatte 11 angeordneten elektronischen Bauteilen 20, 21, 22, 23 erzeugt wird, mittels Wärmeleitung an die Kühlrippen 30, 31, 32, 33 der Kühlplatte 12 abgeführt wird. Die überwiegende Mehrzahl der Kühlrippen 30, 31, 32, 33 sind gleichzeitig als Leitwände 30, 31, 32, 33 zum Leiten der nachfolgend beschriebenen Kühlluft-Strömung 41, 42, 43, 44 ausgebildet.

Insgesamt hat die in Fig. 1 und 2 dargestellte Trägerstruktur 10 die Form einer im Wesentlichen flachen, rechteckigen Platte (nachfolgend auch als Trägerplatte 10 bezeichnet) mit zwei rechteckigen Hauptseiten 11, 12, wobei die eine Hauptseite 11 (nachfolgend auch als Leiterplattenseite 11 bezeichnet) mit elektronischen Bauteilen 20, 21, 22, 23 bestückt ist und die andere Hauptseite 12 (nachfolgend auch als Heatsinkseite 12 bezeichnet) mit Kühlrippen 30, 31, 32, 33 versehen ist. Fig. 1 zeigt eine perspektivische Ansicht auf die Leiterplattenseite 11 der Trägerstruktur 10, während Fig. 2 eine perspektivische Ansicht auf die Heatsinkseite 12 der Trägerstruktur 10 zeigt.

Die in den Figuren dargestellte Elektronik-Anordnung bzw. ihre Trägerplatte 10 ist mit den nachfolgend beschriebenen Abdeckplatten (nicht dargestellt) zusammen als Einschub-Einheit ausgebildet, welche als Ganzes in ein Rack (nicht dargestellt) einschiebbar ist, das für die Aufnahme weiterer ähnlicher Einschub-Einheiten ausgebildet ist. Diejenige Stirnseite der Trägerplatte 10, die nach dem Einschieben in das Rack an der Rackfrontseite angeordnet ist, wird nachfolgend als Frontseite der Trägerplatte 10 bezeichnet, und die zur Frontseite im Wesentlichen parallele Stirnseite, welche den von der Frontseite entfernten Rand der Trägerplatte 10 bildet, wird als Rückseite der Trägerplatte 10 bezeichnet.

An ihrem frontseitigen Rand ist an der Trägerplatte 10 eine im Wesentlichen rechteckige Frontwand 50 rechtwinklig zur Plattenebene der Trägerplatte 10 angebracht. Diese Frontwand 50 steht sowohl leiterplattenseitig als auch heatsinkseitig über die Plattenoberflächen der beiden Hauptflächen der Trägerplatte 10 hinaus vor, wobei die leiterplattenseitig vorstehende Partie 52 der Frontwand 50 mit einer Vielzahl von Durchgängen versehen ist, während die heatsinkseitig vorstehende Partie 51 im Wesentlichen als homogene, durchgehende Wand ausgebildet ist. Die Durchgänge oder Öffnungen in der leiterplattenseitig vorstehenden Frontwandpartie 52 dienen als Lufteinlassöffnungen für die nachfolgend beschriebene Kühlluft-Strömung 41, 42, 43, 44.

Den beiden Längsseiten der Trägerplatte 10 entlang ist je eine sich von der Frontseite zur Rückseite der Trägerplatte 10 erstreckende Seitenwand 60, 65 rechtwinklig zur Trägerplatte 10 angeordnet. Diese beiden Seitenwände 60, 65 stehen heatsinkseitig auf der ganzen Länge über die Plattenoberfläche der heatsinkseitigen Hauptfläche 12 der Trägerplatte 10 hinaus vor und sind dort als durchgehende Wandpartien 61, 66 ausgebildet, während sie leiterplattenseitig lediglich in einem an die Rückseite angrenzenden Bereich 62, 67 über die Plattenoberfläche der leiterplattenseitigen Hauptfläche 11 der Trägerplatte 10 hinaus vorstehen und im übrigen Bereich bündig zu dieser Hauptfläche sind bzw. nicht über sie hinaus vorstehen.

An der Rückseite der Trägerplatte 10 ist rechtwinklig zu dieser eine Rückwand angebracht, welche auf der einen Hälfte 57 der Rückseitenlänge lediglich über die Plattenoberfläche der heatsinkseitigen Hauptfläche 12 der Trägerplatte10 hinaus und auf der anderen Hälfte 58 lediglich über die Plattenoberfläche der leiterplattenseitigen Hauptfläche 11 der Trägerplatte 10 hinaus vorsteht. Die leiterplattenseitig vorstehende Rückwandpartie 58 ist mit Durchgängen versehen, welche als Luftauslassöffnungen für den leiterplattenseitigen Anteil 41, 42 der nachfolgend beschriebenen Kühlluft-Strömung 41, 42, 43, 44 dient. Die leiterplattenseitig freigelassene Rückseitenhälfte wird nach dem Zusammenbau der Trägerplatte 10 zusammen mit den nachfolgend beschriebenen Abdeckplatten zu einer Einschub-Einheit vollständig durch einen Anschlussstecker versperrt, so dass dort keine Kühlluft austreten kann. Leiterplattenseitig kann die Kühlluft lediglich im Bereich der mit Durchgängen versehenen Rückwandpartie 58 durch die Rückwand hindurch austreten.

Die heatsinkseitig vorstehende Rückwandpartie 57 ist durchgehend ausgebildet und für die Kühlluft undurchdringbar. Der heatsinkseitige Anteil 43, 44 der nachfolgend beschriebenen Kühlluft-Strömung 41, 42, 43, 44 tritt durch die heatsinkseitig freigelassene Rückseitenhälfte hindurch aus, welche somit als heatsinkseitige Luftauslassöffnung dient.

Insgesamt ist die Trägerplatte 10 heatsinkseitig entlang der Frontseite, der beiden Längsseiten und der halben Rückseite mit durchgehenden, rechtwinklig zur Trägerplatte angeordneten Randwänden 51, 57, 61, 66 versehen, welche mit gleichmässiger Höhe über die Plattenoberfläche der heatsinkseitigen Hauptfläche 12 der Trägerplatte 10 hinaus vorstehen und dort zur Trägerplatte 10 parallele Luftströmungen zur Trägerplatte 10 hin oder von der Trägerplatte 10 weg verhindern. Leiterplattenseitig ist die Trägerplatte 10 lediglich in den beiden an die Rückseite angrenzenden Bereichen der Längsseiten mit durchgehenden Randwänden 62, 67 versehen, welche zur Trägerplatte 10 parallele Luftströmungen zur Trägerplatte 10 hin oder von der Trägerplatte 10 weg verhindern. Die übrigen Randbereiche sind entweder frei von Randwänden, die über die Plattenoberfläche der leiterplattenseitigen Hauptfläche 11 der Trägerplatte 10 hinaus vorstehen, oder sie sind mit Randwänden 52, 58 versehen, die Durchgangsöffnungen für die Kühlluft aufweisen.

Ungefähr mittig in der frontseitigen Hälfte der Trägerplatte 10 ist ein im Wesentlichen kreisrunder Durchgang 13 in der Trägerplatte 10 ausgebildet, der im Wesentlichen senkrecht durch beide Hauptseiten 11, 12 der Trägerplatte 10 hindurch führt. Ein mit einem Flügelrad versehener Ventilator 16 ist auf der Heatsinkseite 12 der Leiterplatte 10 aufliegend derart aufgesetzt, dass seine axiale Einlassöffnung zum Kühlluft-Durchgang 13 fluchtend angeordnet ist. Die Achse des Flügelrads ist somit im Wesentlichen senkrecht zu den Hauptseiten 11, 12 der Trägerplatte 10 angeordnet. Die Dicke dieses Ventilators 16 (gemessen in Richtung Achse des Flügelrads, welche auch als Ventilatorachse bezeichnet wird) ist derart bemessen, dass der Ventilator 16 heatsinkseitig nicht über die Randwände 51, 57, 61, 66 und/oder die höchsten Kühlrippen 30, 31, 32, 33 hinaus vorsteht. Der Ventilator 16 wird derart betrieben, dass er Kühlluft leiterplattenseitig in den Kühlluft-Durchgang 13 hinein ansaugt und heatsinkseitig radial den Kühlrippen 30, 31, 32, 33 entlang ausbläst.

In der rückseitigen Hälfte der Trägerplatte 10 ist in der Nähe der beiden Seitenränder je ein weiterer Kühlluft-Durchgang 14, 15 ausgebildet, wobei diese beiden weiteren Kühlluft-Durchgänge 14, 15 wiederum im Wesentlichen senkrecht durch beide Hauptseiten 11, 12 der Trägerplatte 10 hindurch führen. Die beiden weiteren Kühlluft-Durchgänge 14, 15 sind unmittelbar neben den längsseitigen Randbereichen der Trägerplatte 10 angeordnet, in denen die Seitenwände 62, 67 leiterplattenseitig über die Plattenoberfläche der Hauptfläche 11 der Trägerplatte 10 hinaus vorstehen.

Die in Fig. 1 und 2 dargestellte Trägerplatte 10 ist weiter leiterplattenseitig und heatsinkseitig mit zur Trägerplatte 10 parallelen Abdeckplatten (nicht dargestellt) versehen, welche zur Plattenebene senkrechte Luftströmungen zur Trägerplatte 10 hin und von der Trägerplatte 10 weg verhindern. Mit diesen Abdeckplatten zusammen ist die Trägerplatte 10 zu einer Einschub-Einheit zusammengebaut, welche als Ganzes in ein Rack (nicht dargestellt) einschiebbar ist. Die Abdeckplatten sind mit zusätzlichen Strömungsleitmitteln wie Wänden, Rippen u.ä. versehen, um die Kühlluftströmung hinsichtlich der Geräuschdämpfung und/oder der Kühleffizienz zu optimieren. Weiter ist die leiterplattenseitige Abdeckplatte mit einer Trennwand versehen, welche die Bereiche um den ersten Kühlluft-Durchgang 13 herum von den Bereichen um die weiteren Kühlluft-Durchgänge 14, 15 herum abgrenzt, um zu verhindern, dass die Kühlluftleiterplattenseitig von den weiteren Kühlluft-Durchgängen 14, 15 zum ersten Kühlluft-Durchgang 13 zurück strömt.

Bei einer anderen, nicht in den Figuren dargestellten Ausführungsart der Erfindung entfallen eine oder beide der erwähnten Abdeckplatten. Die Trägerplatte gemäss dieser Ausführungsart der Erfindung ist nach dem Einschieben in ein Rack sowohl leiterplattenseitig als auch heatsinkseitig unmittelbar neben weiteren Trägerplatten und/oder Rack- bzw. Gehäusewänden angeordnet, die eine ähnliche Plattenform wie die Trägerplatte aufweisen und parallel zu dieser angeordnet sind, so dass im Wesentlichen lediglich zu den Plattenebenen parallele Luftströmungen bewirkt werden.

Zum Zwecke des Einschiebens der Trägerplatte 10 in und des Herausziehens der Trägerplatte 10 aus dem Gehäuse ist an der Frontwand 50 weiter ein Griffbügel 55 angebracht, der im Wesentlichen in der Verlängerung der Trägerplattenebene von der Frontwand 50 aus nach vorne ragt.

Zum Erzeugen einer Kühlluft-Strömung 41, 42, 43, 44 wird der in den Kühlluft-Durchgang 13 eingesetzte Ventilator 16 derart betrieben, dass er die Kühlluft leiterplattenseitig in den Kühlluft-Durchgang 13 hinein ansaugt und heatsinkseitig radial den Kühlrippen 30, 31, 32, 33 entlang ausbläst. Dadurch wird eine Kühlluft-Strömung 41, 42, 43, 44 derart erzeugt, dass die Kühlluft zunächst durch die leiterplattenseitig in der Frontwand 50 ausgebildeten Lufteinlassöffnungen hindurch angesaugt wird. Die Kühlluft-Strömung 41, 42, 43, 44 ist in den Figuren durch die Pfeile 41, 42, 43, 44 dargestellt. Nach dem Durchströmen der Lufteinlassöffnungen strömt die Kühlluft im Wesentlichen parallel zur Trägerplatte 10 deren leiterplattenseitigen Hauptfläche 11 entlang zu dem mit dem Ventilator 16 versehenen Kühlluft-Durchgang 13 hin und kühlt dabei die auf den Strömungspfaden 41, 42, 43, 44 zwischen den Lufteinlassöffnungen und dem Kühlluft-Durchgang 13 liegenden elektronischen Bauteile 20, 21 der Elektronik-Anordnung ab.

Durch den Ventilator 16 erzwungen, durchströmt anschliessend die gesamte Kühlluft 41, 42, 43, 44 den mit dem Ventilator 16 versehenen Kühlluft-Durchgang 13 und gelangt dadurch auf die Heatsinkseite 12 der Trägerplatte 10.

Dort wird ein Teil 43, 44 der Kühlluft-Strömung 41, 42, 43, 44 mittels einigen der als Kühlluft-Leitwände 30, 31 ausgebildeten Kühlrippen 30, 31 von dem mit dem Ventilator 16 versehenen Kühlluft-Durchgang 13 zur Rückseite der Trägerplatte 10 geleitet, wobei mittels Konvektion Wärme von den diesen Teil 43, 44 der Kühlluft-Strömung 41, 42, 43, 44 leitenden Leitwänden 30, 31 auf die Kühlluft abgeführt wird. Dieser Teil derKühlluft-Strömung 43, 44 wird anschliessend durch die als heatsinkseitige Luftauslassöffnung dienende Hälfte der Trägerplattenrückseite hindurch, die heatsinkseitig rückwandfrei ist, ausgeblasen.

Ein anderer Teil 41, 42 der Kühlluft-Strömung 41, 42, 43, 44 wird mittels weiterer gleichzeitig als Kühlluft-Leitwände 32, 33 ausgebildeten Kühlrippen 32, 33 von dem mit dem Ventilator 16 versehenen Kühlluft-Durchgang 13 zu den beiden weiteren Kühlluft-Durchgängen 14, 15 in den rückseitigen Seitenbereichen der Trägerplatte 10 geleitet und kühlt dabei konvektiv die Leitwände 32, 33 ab, welche diesen Teil 41, 42 der Kühlluft-Strömung 41, 42, 43, 44 leiten. Anschliessend strömt dieser Teil 41, 42 der Kühlluft-Strömung 41, 42, 43, 44 durch die beiden weiteren Kühlluft-Durchgänge 14, 15 hindurch wiederum auf die Leiterplattenseite 11 der Trägerplatte 10 und strömt dort an weiteren elektronischen Bauteilen 22, 23 vorbei zur leiterplattenseitigen Rückseite der Trägerplatte 10. Dabei werden die auf dem Strömungspfad zwischen den weiteren Durchgängen 14, 15 und der Rückseite der Trägerplatte 10 angeordneten elektronischen Bauteile 22, 23 ebenfalls konvektiv abgekühlt. Danach wird dieser Teil 41, 42 der Kühlluft-Strömung 41, 42, 43, 44 durch die als leiterplattenseitige Luftauslassöffnungen dienenden Durchgänge in der leiterplattenseitig vorstehenden Rückwandpartie 58 hindurch über die Rückseite der Trägerplatte 10 hinaus ausgeblasen.

Zusammenfassend ist festzustellen, dass durch die Erfindung eine Elektronik-Anordnung mit einer Kühlvorrichtung geschaffen wird, die platzsparend ist und eine effiziente Kühlung von elektronischen Bauteilen der Elektronik-Anordnung ermöglicht.

## Patentansprüche

1. Elektronik-Anordnung mit wenigstens einem Ventilator (16) und wenigstens einer im Wesentlichen flachen Trägerstruktur (10), die mit einem oder mehreren elektronischen Bauteilen (20, 21, 22, 23) bestückt und mit einer oder mehreren Kühlrippen (30, 31, 32, 33) versehen ist, **gekennzeichnet durch** einen in der Trägerstruktur (10) ausgebildeten Kühlluft-Durchgang (13), wobei der Ventilator (16) und der Kühlluft-Durchgang (13) derart ausgebildet und angeordnet sind, dass der Ventilator (16) eine Kühlluft-Strömung (41, 42, 43, 44) erzeugt, so dass die Kühlluft zunächst in wenigstens ein elektronisches Bauteil (20, 21) und/oder eine Kühlrippe kühlender Funktion auf der einen Seite (11) der Trägerstruktur (10) entlang strömt, dann **durch** den Kühlluft-Durchgang (13) hindurch strömt und danach in wenigstens ein elektronisches Bauteil und/oder eine Kühlrippe (30, 31, 32, 33) kühlender Funktion auf der anderen Seite (12) der Trägerstruktur (10) entlang strömt.

2. Elektronik-Anordnung nach Anspruch 1, **dadurch gekennzeichnet, dass** der Ventilator (16) an der Trägerstruktur (10) oder an einer mit der Trägerstruktur verbundenen Haltevorrichtung angebracht ist.

3. Elektronik-Anordnung nach Anspruch 2, **dadurch gekennzeichnet, dass** der Ventilator (16) derart bemessen und an der Trägerstruktur (10) angeordnet ist, dass er in Richtung senkrecht zu den Oberflächen der Hauptseiten der flachen Trägerstruktur (10) nicht über die höchsten Bauteile (20, 21, 22, 23) und/oder Kühlrippen (30, 31, 32, 33) hinaus vorsteht.

4. Elektronik-Anordnung nach Anspruch 2 oder 3, **dadurch gekennzeichnet, dass** der Ventilator (16) in radialer Anordnung im Kühlluft-Durchgang (13) oder in dessen unmittelbaren Umgebung angeordnet ist.

5. Elektronik-Anordnung nach Anspruch 3 oder 4, **dadurch gekennzeichnet, dass** der Ventilator an einem oder an beiden axialen Längsenden je mit einer quer zur Ventilatorachse angeordneten Abdeckung versehen ist, welche das Ansaugen bzw. das Ausblasen von Luft in axialer Richtung verhindern.

6. Elektronik-Anordnung nach einem der Ansprüche 1 bis 5, **dadurch gekennzeichnet, dass** die Trägerstruktur (10) eine einseitig mit elektronischen Bauteilen (20, 21, 22, 23) bestückte Leiterplatte (11) und eine einseitig mit Kühlrippen (30, 31, 32, 33) versehene Kühlplatte (12) umfasst, wobei die Kühlplatte (12) an ihrer kühlrippenfreien Seite mit der unbestückten Seite der Leiterplatte (11) verbunden ist.

7. Elektronik-Anordnung nach einem der Ansprüche 1 bis 6, **gekennzeichnet durch** eine Anordnung der elektronischen Bauteile (20, 21, 22, 23), der Kühlrippen (30, 31, 32, 33) und des Ventilators (16) derart, dass die **durch** den Ventilator (16) erzeugte Kühlluft-Strömung (41, 42, 43, 44) zunächst wenigstens ein elektronisches Bauteil (20, 21) auf der einen Seite (11) der Trägerstruktur (10) kühlt, dann **durch** den Kühlluft-Durchgang (13) hindurch strömt und danach wenigstens eine Kühlrippe (30, 31, 32, 33) auf der anderen Seite (12) der Trägerstruktur (10) kühlt.

8. Elektronik-Anordnung nach einem der Ansprüche 1 bis 7, **dadurch gekennzeichnet, dass** wenigstens einige der Kühlrippen (30, 31, 32, 33) nach Art von Strömungsleitwänden (30, 31, 32, 33) ausgebildet und angeordnet sind, welche auf wenigstens einer Seite (12) der Trägerstruktur (10) Kanalwände für die Kühlluft-Strömung (41, 42, 43, 44) definieren.

9. Elektronik-Anordnung nach Anspruch 8, **dadurch gekennzeichnet, dass** auf der von der Trägerstruktur abgewandten Seite der Kühlluft-Kanäle definierenden Kühlrippen eine zur flachen Trägerstruktur im Wesentlichen parallele Abdeckplatte oder ein Abdeckelement derart angeordnet ist, dass wenigstens einer der Kühlluft-Kanäle auf zwei Seiten durch Kühlrippen, auf einer dritten Seite durch die Trägerstruktur und auf einer dieser dritten Seite gegenüberliegenden vierten Seite durch die Abdeckplatte bzw. das Abdeckelement begrenzt ist.

10. Elektronik-Anordnung nach einem der Ansprüche 1 bis 9, **dadurch gekennzeichnet, dass** in der Trägerstruktur (10) wenigstens ein weiterer Kühlluft-Durchgang (14, 15) ausgebildet ist und Strömungsleitmittel (30, 31) derart angeordnet sind, dass wenigstens ein Teil (43, 44) der Kühlluft nach dem Entlangströmen auf der ersten Seite (11) der Trägerstruktur (10) und dem Durchströmen des von der ersten (11) auf die zweite Seite (12) der Trägerstruktur (10) führenden ersten Kühlluft-Durchgangs (13) mit Hilfe der Strömungsleitmittel (30, 31) auf der zweiten Seite (12) der Trägerstruktur (10) zum weiteren Kühlluft-Durchgang (14, 15) geleitet wird und durch diesen hindurch wieder auf die erste Seite (11) der Trägerstruktur (10) strömt, um danach in wenigstens ein elektronisches Bauteil (22, 23) und/oder eine Kühlrippe kühlender Funktion wiederum auf der ersten Seite (11) der Trägerstruktur (10) entlang zu strömen.

11. Elektronik-Anordnung nach einem der Ansprüche 1 bis 10, **gekennzeichnet durch** eine Anordnung des Ventilators (16), des bzw. der Kühlluft-Durchgänge (13, 14, 15) und gegebenenfalls der Strömungsleitmittel (30, 31, 32, 33) derart, dass die Kühlluft **durch** einen Lufteinlass angesaugt wird, der in der Nähe einer ersten Stirnseite der Trägerstruktur (10) angeordnet ist, und dass die Kühlluft **durch** einen Luftauslass abgeblasen wird, der in der Nähe von einer dieser ersten Stirnseite verschiedenen Stirnseite der Trägerstruktur (10) angeordnet ist.

## Claims

1. Electronics structure with at least one fan (16) and at least one substantially flat carrier structure (10) which is equipped with one or a plurality of electronic components (20, 21, 22, 23) and is provided with one or a plurality of cooling fins (30, 31, 32, 33), **characterized by** a cooling-air passageway (13) formed in the carrier structure (10), wherein the fan (16) and the cooling-air passageway (13) are formed and arranged in a manner such that the fan (16) produces a flow of cooling air (41, 42, 43, 44) so that the cooling air first of all flows along on one side (11) of the carrier structure (10) with the function of cooling at least one electronic component (20, 21) and/or one cooling fin, then flows through the cooling-air passageway (13), and subsequently flows along on the other side (12) of the carrier structure (10) with the function of cooling at least one electronic component and/or one cooling fin (30, 31, 32, 33).

2. Electronics structure according to Claim 1, **characterized in that** the fan (16) is mounted on the carrier structure (10) or on a holding device connected to the carrier structure.

3. Electronics structure according to Claim 2, **characterized in that** the fan (16) is dimensioned and arranged on the carrier structure (10) in a manner such that it does not project beyond the tallest components (20, 21, 22, 23) and/or cooling fins (30, 31, 32, 33) in a direction perpendicular to the surfaces of the main faces of the flat carrier structure (10).

4. Electronics structure according to Claim 2 or Claim 3, **characterized in that** the fan (16) is arranged in a radial arrangement in the cooling-air passageway (13) or in the immediate vicinity thereof.

5. Electronics structure according to Claim 3 or Claim 4, **characterized in that** the fan is provided, on one or on both axial longitudinal ends, with a respective cover which is arranged transversely relative to the fan axis and which prevents the taking-in or blowing-out of air in an axial direction.

6. Electronics structure according to any one of Claims 1 to 5, **characterized in that** the carrier structure (10) includes a printed circuit board (11) equipped on one side with electronic components (20, 21, 22, 23), and a heat-sink plate (12) provided on one side with cooling fins (30, 31, 32, 33), wherein the heat-sink plate (12) is connected, on its side which is free of cooling fins, to the unequipped side of the printed circuit board.

7. Electronics structure according to any one of Claims 1 to 6, **characterized by** an arrangement of the electronic components (20, 21, 22, 23), of the cooling fins (30, 31, 32, 33), and of the fan (16) such that the flow of cooling air (41, 42, 43, 44) produced by the fan (16) first of all cools at least one electronic component (20, 21) on the one side (11) of the carrier structure (10), then flows through the cooling-air passageway (13), and subsequently cools at least one cooling fin (30, 31, 32, 33) on the other side (12) of the carrier structure (10).

8. Electronics structure according to any one of Claims 1 to 7, **characterized in that** at least some of the cooling fins (30, 31, 32, 33) are formed and arranged in the manner of flow-guide walls (30, 31, 32, 33) which define on at least one side (12) of the carrier structure (10) channel walls for the flow of cooling air (41, 42, 43, 44).

9. Electronics structure according to Claim 8, **characterized in that** a covering plate or a covering element substantially parallel to the flat carrier structure is arranged on the side remote from the carrier structure of the cooling fins defining cooling-air channels, in a manner such that at least one of the cooling-air channels is delimited on two sides by cooling fins, on a third side by the carrier structure, and on a fourth side opposite that third side by the covering plate or the covering element.

10. Electronics structure according to any one of Claims 1 to 9, **characterized in that** at least one further cooling-air passageway (14, 15) is formed in the carrier structure (10) and flow-guide means (30, 31) are arranged in a manner such that at least a portion (43, 44) of the cooling air, after flowing along on the first side (11) of the carrier structure (10) and flowing through the first cooling-air passageway (13) leading from the first (11) to the second (12) side of the carrier structure (10), is guided by the flow-guide means (30, 31) on the second side (12) of the carrier structure (10) to the further cooling-air passageway (14, 15) and flows through the further cooling-air passageway (14, 15) back to the first side (11) of the carrier structure (10) in order subsequently to flow along on the first side (11) of the carrier structure (10) again, with the function of cooling at least one electronic component (22, 23) and/or one cooling fin.

11. Electronics structure according to any one of Claims 1 to 10, **characterized by** an arrangement of the fan (16), of the cooling-air passageway or passageways (13, 14, 15), and of the flow-guide means (30, 31, 32, 33), where they are provided, such that the cooling air is taken in through an air-inlet which is arranged in the vicinity of a first end face of the carrier structure (10), and that the cooling air is blown out through an air-outlet which is arranged in the vicinity of an end face of the carrier structure (10) other than that first end face.

## Revendications

1. Dispositif électronique avec au moins un ventilateur (16) et au moins une structure porteuse pour l'essentiel plate (10), qui est équipé d'un ou de plusieurs composants électroniques (20, 21, 22, 23) et pourvu d'une ou de plusieurs ailettes de refroidissement (30, 31, 32, 33), **caractérisé par** un passage d'air de refroidissement (13) formé dans la structure porteuse (10), le ventilateur (16) et le passage d'air de refroidissement (13) étant formés et disposés de telle façon que le ventilateur (16) génère un flux d'air de refroidissement (41, 42, 43, 44) de sorte que l'air de refroidissement s'écoule d'abord le long d'au moins un composant électronique (20, 21) et/ou une ailette de refroidissement de fonction refroidissante sur une face (11) de la structure porteuse (10), ensuite au travers du passage d'air de refroidissement (13) et ensuite le long d'au moins un composant électronique (20, 21) et/ou une ailette de refroidissement (30, 31, 32, 33) de fonction refroidissante sur l'autre face (12) de la structure porteuse (10).

2. Dispositif électronique selon la revendication 1, **caractérisé en ce que** le ventilateur (16) est monté sur la structure porteuse (10) ou sur un dispositif de fixation relié à la structure porteuse.

3. Dispositif électronique selon la revendication 2, **caractérisé en ce que** le ventilateur (16) est dimensionné et monté sur la structure porteuse (10) de telle façon qu'il ne fasse pas saillie dans la direction perpendiculaire aux surfaces des faces principales de la structure porteuse plate (10) au-dessus des composants les plus hauts (20, 21, 22, 23) et/ou des ailettes de refroidissement (30, 31, 32, 33).

4. Dispositif électronique selon la revendication 2 ou 3, **caractérisé en ce que** le ventilateur (16) est monté dans un agencement radial dans le passage d'air de refroidissement (13) ou dans son voisinage proche.

5. Dispositif électronique selon la revendication 3 ou 4, **caractérisé en ce que** le ventilateur (16) est pourvu à une ou aux deux extrémités longitudinales axiales d'une couverture disposée transversalement à l'axe du ventilateur, laquelle couverture empêche que l'air soit aspiré ou soufflé dans la direction axiale.

6. Dispositif électronique selon l'une quelconque des revendications 1 à 5, **caractérisé en ce que** la structure porteuse (10) comprend une plaquette de circuit imprimé (11) équipée d'un côté de composants électroniques (20, 21, 22, 23) et une plaquette de refroidissement (12) pourvue d'un côté d'ailettes de refroidissement (30, 31, 32, 33), la plaquette de refroidissement (12) étant reliée par sa face exempte d'ailettes de refroidissement à la face non équipée de la plaquette de circuit imprimé (11).

7. Dispositif électronique selon l'une quelconque des revendications 1 à 6, **caractérisé par** un agencement des composants électroniques (20, 21, 22, 23), des ailettes de refroidissement (30, 31, 32, 33) et du ventilateur (16) tel que le flux d'air de refroidissement (41, 42, 43, 44) généré par le ventilateur (16) refroidit d'abord au moins un composant électronique (20, 21) sur une face (11) de la structure porteuse (10), qu'il s'écoule ensuite au travers du passage d'air de refroidissement (13) et qu'il refroidit ensuite au moins une ailette de refroidissement (30, 31,32, 33) sur l'autre face (12) de la structure porteuse (10).

8. Dispositif électronique selon l'une quelconque des revendications 1 à 7, **caractérisé en ce qu'**au moins quelques-unes unes des ailettes de refroidissement (30, 31,32, 33) sont disposées et formées à la manière de parois de déflection qui définissent au moins sur une face (12) de la structure porteuse (10) des parois de canaux pour le flux d'air de refroidissement (41, 42, 43, 44).

9. Dispositif électronique selon la revendication 8, **caractérisé en ce qu'**une plaquette de recouvrement ou un élément de recouvrement pour l'essentiel parallèle à la structure porteuse plate est disposé sur le côté, opposé à la structure porteuse, des ailettes de refroidissement définissant des canaux d'air de refroidissement de sorte qu'au moins un des canaux d'air de refroidissement soit limité sur deux côtés par des ailettes de refroidissement, sur un troisième côté par la structure porteuse et sur un quatrième côté situé en face de ce troisième côté par la plaquette de recouvrement ou l'élément de recouvrement.

10. Dispositif électronique selon l'une quelconque des revendications 1 à 9, **caractérisé en ce qu'**au moins un autre passage d'air de refroidissement (14, 15) est formé dans la structure porteuse (10) et **en ce que** des moyens de déflection de flux (30, 31) sont disposés de telle façon qu'au moins une partie (43, 44) de l'air de refroidissement, après l'écoulement le long de la première face (11) de la structure porteuse (10) et après l'écoulement au travers du premier passage d'air de refroidissement (13) allant de la première face (11) à la deuxième face (12) de la structure porteuse (10), soit dirigée à l'aide des moyens de déflection de flux (30, 31) sur la deuxième face (12) de la structure porteuse (10) vers l'autre passage d'air de refroidissement (14, 15) et qu'elle s'écoule à travers celui-ci de nouveau sur la première face (11) de la surface porteuse (10) afin de s'écouler ensuite de nouveau sur la première face le long d'au moins un composant électronique (22, 23) et/ou une ailette de refroidissement de fonction refroidissante (11).

11. Dispositif électronique selon l'une quelconque des revendications 1 à 10, **caractérisé par** un agencement du ventilateur (16), du ou des passages d'air de refroidissement (13, 14, 15) et le cas échéant des moyens de déflection de flux (30, 31, 32, 33) tel que l'air de refroidissement soit aspiré par une entrée d'air qui est disposée à proximité d'un premier côté frontal de la structure porteuse (10) et tel que l'air de refroidissement soit soufflé à travers une sortie d'air qui est disposée à proximité d'un côté frontal de la structure porteuse (10) différent de ce premier côté frontal.
